(19)

**Europäisches Patentamt**
**European Patent Office**
**Office européen des brevets**

(11) **EP 4 481 647 A1**

(12) **EUROPEAN PATENT APPLICATION**

(43) Date of publication:
**25.12.2024 Bulletin 2024/52**

(21) Application number: **23180689.4**

(22) Date of filing: **21.06.2023**

(51) International Patent Classification (IPC):
**G06Q 10/0639** (2023.01)      **G06Q 50/06** (2024.01)

(52) Cooperative Patent Classification (CPC):
**G06Q 50/06; G06Q 10/0639**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ABB SCHWEIZ AG**
**5400 Baden (CH)**

(72) Inventors:
• **GUTERMUTH, Georg**
**69115 Heidelberg (DE)**

• **PRIMAS, Bernhard**
**68165 Mannheim (DE)**
• **BISKOPING, Matthias**
**69493 Hirschberg (DE)**
• **SCHLOEDER, Matthias**
**69126 Heidelberg (DE)**
• **KOTRIWALA, Arzam Muzaffar**
**68526 Ladenburg (DE)**

(74) Representative: **Maiwald GmbH**
**Engineering**
**Elisenhof**
**Elisenstrasse 3**
**80335 München (DE)**

(54) **COMPUTER-IMPLEMENTED METHOD FOR DETERMINING AN ENERGY RATIO FOR A CONSUMED ENERGY**

(57)     Computer-implemented method for determining an energy ratio for a consumed energy comprising: Providing an energy network model configured to describe an energy flow between a plurality of assets in an energy network, wherein at least one asset of the plurality of assets consumes energy, wherein the energy network comprises further as assets a first energy source and a second energy source, wherein the energy flow comprises a first energy flow from the first energy source and a second energy flow from the second energy source; Receiving a load demand data for the energy network and power source data for the energy network generated by the first energy source; Controlling and tracking the first energy flow from the first energy source to the plurality of assets in the energy network and the second energy flow from the second energy source to the plurality of assets in the energy network based on the energy network model and the received load demand data and the received power source data; Tracking one or more consuming times of the at least one energy consuming asset, Determining an energy ratio for the at least one energy consuming asset based on the tracked first energy flow and the second energy flow and the tracked consuming time of the at least one energy consuming asset; Providing the determined energy ratio for further processing.

Figure 1

**Description**

**FIELD OF THE INVENTION**

The present invention relates to a computer-implemented method for determining an energy ratio for a consumed energy, to a corresponding data processing device, to a computer program and to a computer-readable medium.

**BACKGROUND OF THE INVENTION**

Energy consuming assets in energy networks are known in the state-of-the-art. There are different strategies to provide energy to these energy consuming assets. The energy in such a network may stem from different energy sources. The way of controlling a corresponding energy flow is a challenging task.

It has now become apparent that there is a further need to provide a method for determining an energy ratio for a consumed energy.

**SUMMARY OF THE INVENTION**

In view of the above, it is an object of the present invention to provide a method for determining an energy ratio for a consumed energy. In particular, it is an object of the present invention to provide an improved method for determining an energy ratio for consumed energy in a energy network. These and other objects, which become apparent upon reading the following description, are solved by the subject-matter of the independent claims. The dependent claims refer to preferred embodiments of the invention.

In one aspect, a computer implemented method for determining an energy ratio for consumed energy is provided, comprising: providing an energy network model configured to describe an energy flow between a plurality of assets in an energy network, wherein at least one asset of the plurality of assets consumes energy, wherein the energy network comprises further as assets a first energy source and a second energy source, wherein the energy flow comprises a first energy flow from the first energy source and a second energy flow from the second energy source; receiving a load demand for the energy network and power source data for the energy network generated by the first energy source; controlling and tracking the first energy flow from the first energy source to the plurality of assets in the energy network and the second energy flow from the second energy source to the plurality of assets in the energy network based on the energy network model and the received load demand data and the received power source data; tracking one or more consuming times of the at least one energy consuming asset; determining an energy ratio for the at least one energy consuming asset based on the tracked first energy flow and the second energy flow and the tracked consuming time of the at least one energy consuming asset consuming; providing the determined energy ratio for further processing.

The term energy ratio, as used herein, is to be understood broadly and may relate to a ratio that is described by a share of a consumed energy (i.e. energy amount) provided by one asset (e.g. PV system) in relation to the total consumed energy provided by a plurality of assets (i.e. PV system and electrical grid). The energy ratio may be formed by at least a first amount of energy from the first energy source and a second amount of energy from the second energy source. The one or more energies stem from of one or more energy sources. For example, the asset is a machine tool that produces a product and the consumed energy stems from a first energy source and a second energy source, wherein the first energy source provided 50% of the consumed energy and the second energy source provided 50% of the consumed energy. In this example, the first energy source is a green energy source, for example a photovoltaic system, and the second energy source is an electrical grid. The corresponding energy ratio may be in the present example an energy ratio 50% green energy share. The energy ratio may relate to the used energy mix for a product (e.g., for producing the product) or alternatively for a service. The service may comprise charging an electrical vehicle.

The term consumed energy, as used herein, is to be understood broadly and may relate to an amount of energy that is consumed by an asset. The consumed energy may comprise one or more energy amounts provided by one or more energy sources.

The term energy network model, as used herein, is to be understood broadly and may relate to any model that is configured to describe an energy flow between a plurality of assets in an energy network. The energy flow may also comprise a direction, e.g. inflow or outflow of an asset. The energy network model may be at a deterministic model. The energy network model may a network graph model. The energy network model may be a time-dependent model. The energy network model may comprise at least one asset that consumes energy and at least two assets that serve as energy source for that energy-consuming asset. The energy network may preferably be an electrical energy network.

The term energy network, as used herein, is to be understood broadly and may preferably relate to a physical network between a plurality of assets that provide, store, and/or consume energy.

The assets are connected together for example by power lines for the transmission of the electrical energy/-power. The energy network may preferably be an electrical energy network. The energy network, in particular the one or more assets (i.e. energy source, battery energy storage, energy consuming asset) may comprise one or more controls configured to receive control commands from a data processing device configured to carry out the method described above. The respective controls may further be configured to exchange data with said data processing device.

The term energy flow, as used herein, is to be understood broadly and preferably relates to an amount of energy that is provided per time. The energy flow may be expressed by the unit W. The energy flow may comprise also a direction that relates to inflow or a outflow of an asset, an energy soure and/or a battery energy storage. The energy flow may be controlled by a control of the respective asset (i.e. energy source). The energy flow may then further be tracked and used in the method for further calculations, in particular the calculation of the energy ratio.

The term asset, as used herein, is to be understood broadly and may relate to any physical entity that consumes energy, provides energy, and/or stores energy. That asset may be a machine tool, an electrical charger, a battery storage system, an electrical grid, a energy source.

The term energy source, as used herein, is to be understood broadly and may relate to any physical entity that is configured to provide energy to an asset. The energy source may be one of the following: a PV system, a wind turbine, a water turbine, a diesel aggregate, a coal power plant, a nuclear power plant, a gas power plant and hydrogen fuel cell. The second energy source may prerferably an electrical grid. The first energy source may be preferably any but the electrical grid.

The term first energy flow, as used herein, is to be understood broadly and may relate to an energy flow from the first energy source to an asset. For example, the first energy flow may be an energy flow from a wind turbine.

The term second energy flow, as used herein is to be understood broadly may relate to an energy flow from the second energy source to an asset. For example, the second energy flow may be an energy flow from an electrical grid. Preferably the second energy flow stems from an electrical grid.

The term load demand data, as used herein, is to be understood broadly and may relate to any load demand for an energy network. The load demand data may preferably comprise a total amount of energy for the energy network. The load demand data may relate to a time period. The time period may comprise 30min, 20min or 15min. It should be noted that also smaller or larger time periods may be used in the method. The load demand data may stem from a forecast.

The term power source data, as used herein, is to be understood broadly and may relate to a an energy flow from a power source. The power source data may also comprise a time period for which that energy flow is available. The power source data may stem from a forecast.

The term consuming time, as used herein, is to be understood broadly and may preferably relate to a time in which an asset consumes energy from a first energy source and/or a second energy source or any further energy source. For example, the consuming time for the first energy source comprises 30 minutes and the consuming time for the second energy source comprises 20 minutes. The consuming time may be received from a control of an asset that logs the consuming time of the asset.

In other words, the basic idea of the invention may entail a use of a energy network model and a load demand for the energy network and available power source in order to control an energy flow in the energy network and to determine an energy ratio for a product or a service provided in the energy network. The second energy source may preferably be the electrical grid. In case, the first energy source, e.g. a wind turbine doesn't satisfy the energy load demand the necessary difference of energy may preferably filled with energy from the electrical grid. Fluctuations of the available power from the first power source are considered by uncertainty measures and/or bounds. It should be noted that method also works in case the second energy source is not the electrical grid but another energy source that may compensate such a fluctuation (e.g. coal-fired power plant). It should be noted that the energy network model is used to describe a real physical energy network and is further used in the described method to track and control energy flows. The link between the energy network model and the real physical energy network is established by data processing device carrying out the described method. The method may be advantageously scalable, which means that it works for a plurality of assets, in particular of energy consuming assets, energy sources and battery energy storages. This may advantageously enable the provision of products or services with a specific energy ratio. This may be important for consumers trying to save the planet. This may further allow to track a sustainability of products or services.

In an embodiment of the method, the determining of the energy ratio may be based on an integral of the first energy flow and second energy flow over the tracked consuming time. An integration of an energy flow over a time results in a corresponding energy. By integrating the first energy flow and the second energy flow over their corresponding consuming times the respective energies can be calculated. The energy ratio may then be calculated by dividing the first energy through the sum of the first energy and the second energy. This may adavantageously lead to a precise determining of the energy ratio.

In an embodiment of the method, the load demand data for the energy network and power source data for the energy network generated by the first energy source may be based on a forecast. The forecast may be based historical data. The forecast may be received by an interface, e.g. a HMI or an API. The forecast may comprise different time periods (min, h, days). In other words, the forecast may be used as input for the energy network model in order to control the energy flows in the energy network. This may enable the use of the method even when no real time data of the assets are available.

This may lead to a flexible use of the method. It should be noted, that this also applies in case a plurality of energy sources and/or energy consuming assets are considered by the method.

In an embodiment, the power source data for the energy network generated by the first energy source may be received in realtime. The power source data may be directly received from the control of the first energy source and transmitted by an interface, an API or an online portal to an device executing the described method. The real time power source data may be more accurate than the forcecast data. This may lead to a more accurate controlling of the energy flows and to a more accurate determining of the energy ratios. The term real time, as used herein, is to be understood broadly and may preferably be a relative term that relates to a time step of the energy network model. Hence, also in case every power source data that is received every minute may be in real time data in case the time step of the energy network model is larger, e.g. 5 minutes. It should be noted, that this also applies in case a plurality of energy sources is considered by the method.

In an embodiment of the method, the load demand data for the energy network and/or the power source data for the energy network generated by the first energy source may be associated with respective uncertaintity measures. The term uncertainty measure, as used herein, is to be understood broadly and may relate to any parameter that considers an uncertaintity of the power source data. The uncertainty measure may be applied to the power source data. E.g., the uncertaintity measure for the power source data may be multiplied with power source data. E.g., the uncertainty measure may comprise a value of 95%. This may advantageously lead to a conservative estimation of the power source data. E.g. in case of a PV system as energy source and an uncertainty measure of 95%, the other 5% stem from the second source which may be in this example the electrical grid. This may be advantageous regarding the reliability of the determined energy ratio. The uncertainty measure may be applied to the load demand data. E.g., the uncertainty measure for the load demand data may comprise value of 105%. The uncertainty measure may be multiplied with the load demand data. This may advantageously lead to a safe estimation of the load demand data. It should be noted that in case of a pluralitly of energy sources, e.g. more than two energy sources, also uncertainty measures for the third and further energy sources are considered by the method. The same applies for a plurality of energy consuming assets in the energy network.

In an embodiment of the method, the load demand data for the energy network may comprise an upper bound and the power source data for the energy network generated by the first energy source comprise a lower bound. The term upper bound, as used herein, is to be understood broadly and may relate to an upper threshold. The term lower bound, as used herein, is to be understood broadly may relate to an lower threshold. The upper bound limits the value of the load demand data. The upper bound may be derived from the forecast. This may increase the reliability of the energy network model. The lower bound limits the value of the power source data. This may increase the reliability of the energy network model, in particular of the determining of the energy ratio.

In an embodiment of the method, the energy source may be one of the following: photovoltaic system, wind turbine, water turbine, electrical grid, diesel generator and hydrogen fuel cell. The second energy source may preferably be an electrical grid.

In an embodiment of the method, the energy network model may be a time dependent network graph model. The time dependent energy network model may comprise a time step of e.g. 5 min or 10 min.

In an embodiment of the method, the energy network may comprise as an asset a battery energy storage for storing energy, and may further comprise controlling and tracking the first energy flow from the first energy source to the battery energy storage and the second energy flow from the second energy source to the battery energy storage based on the energy network model and the received load demand data and the received power source data and tracking one or more charging times of the battery energy storage and determining an energy storage energy ratio based on the tracked first energy flow and the second energy flow and the tracked charging time. In other words, the method controls and tracks the inflow of the energy sources to the battery energy storage and therefore it is known at every time how much energy from a first energy source or a second energy source is currently stored in the battery energy storage. This information is further used to determine an battery energy ratio. The battery energy ratio, as used herein, is to be understood broadly and may preferably relate to a proportion of the first energy from the first energy source to the sum of the first energy from the first energy source and the second energy from the second energy source. The energy may be calculated by integrating the energy flow over the charging time. This information may be used to determine the battery energy ratio. This may advantagageously increase the level of detail of the energy network model. The same applies for a plurality of energy sources in the energy network.

In an embodiment of the method, the method may further comprise controlling and tracking a first battery energy flow and a second battery energy flow from the battery energy storage to the plurality of assets in the energy network, wherein the first battery energy flow is based on a first stored energy that relates to the first energy flow and the second battery energy flow is based on a second stored energy that relates to the second energy flow, wherein the tracked first battery energy flow and second battery energy flow are used for determining the energy ratio for the at least one energy consuming asset and further tracking one or more discharging times of the battery energy storage and determining the energy storage energy ratio based on the tracked first energy flow, second energy flow, first battery energy flow, second battery energy flow, charging time and discharging time. In other words, the battery energy storage is treated as an special energy source that comprises energy from different energy sources. The inflow and outflow of energy sources to the battery energy storage is controlled and tracked and used for the determining of the energy ratio of an energy consuming asset. This may advantageously increase the level of detail of the energy network model and therefore the quality of controlling in determining an energy ratio in the energy network. The same applies for a plurality of energy sources in the energy network.

In an embodiment of the method, the controlling and tracking the first energy flow from the first energy source to the plurality of assets in the energy network and the second energy flow from the second energy source to the plurality of assets in the energy network may be further based on a distribution logic, wherein preferably the distribution logic is dynamic. The term distribution logic, as used herein, is to be understood broadly and preferably relates to strategy setting a predefined target value for the energy ratio for the energy consuming assets. E.g. the energy ratio should be 50% of the first energy from the first energy soure. The distribution logic then may control the the energy flow from the first energy source and the second energy source such that the respective energy consuming asset receives half of its energy from each of the first and second energy source. The same applies for a plurality of energy sources in the energy network.

In an embodiment of the method, more than one asset of the plurality of assets may consume energy. It should be further noted that also more than two energy sources may be taken into account by the method. This may advantageously lead to a scalability of the use of the method.

A further aspect of the present disclosure relates to a data processing device comprising means for carrying out the method described above.

A further aspect of the present disclosure relates to a computer program comprising instructions which, when the program is executed by a computer, cause the computer to carry out the method described above.

A further aspect of the present disclosure relates to a computer-readable medium comprising instructions which, when executed by a computer, cause the computer to carry out the method described above.

Devices or means thereof according to one or more example embodiments may be implemented using hardware, software, and/or a combination thereof. For example, hardware devices may be implemented using processing circuitry such as, but not limited to, a processor, Central Processing Unit (CPU), a controller, an arithmetic logic unit (ALU), a digital signal processor, a microcomputer, a field programmable gate array (FPGA), a System-on-Chip (SoC), a programmable logic unit, a microprocessor, or any other device capable of responding to and executing instructions in a defined manner.

Devices or means thereof may include one or more interface circuits. In some examples, the interface circuits may include wired or wireless interfaces that are connected to a local area network (LAN), the Internet, a wide area network (WAN), or combinations thereof. The functionality of any given device or unit of the present disclosure may be distributed among multiple units or devices that are connected via interface circuits.

Devices or means thereof according to one or more example embodiments may also include one or more storage devices. The one or more storage devices may be tangible or non-transitory computer-readable storage media, such as random access memory (RAM), read only memory (ROM), a permanent mass storage device (such as a disk drive), solid state (e.g., NAND flash) device, and/or any other like data storage mechanism capable of storing and recording data. The one or more storage devices may be configured to store computer programs, program code, instructions, or some combination thereof.

Any disclosure and embodiments described herein relate to the methods, the device, the computer program, computer-readable medium lined out above and vice versa. Advantageously, the benefits provided by any of the embodiments and examples equally apply to all other embodiments and examples and vice versa.

## BRIEF DESCRIPTION OF THE DRAWINGS

Exemplary embodiments of the invention will be described in the following drawings.

Figure 1 shows a flowchart of a computer implemented-method for determining an energy ratio for a consumed energy;
Figure 2 shows a energy network;
Figure 3 shows a corresponding energy network model;
Figure 4 shows a corresponding energy network model;
Figure 5 shows a forecast of an energy source with an applied uncertainty measure
Figure 6 shows a possible evolution of the energy content for battery storage over time; and
Figure 7 shows an energy network model for the production of a single good

## DETAILED DESCRIPTION OF EMBODIMENTS

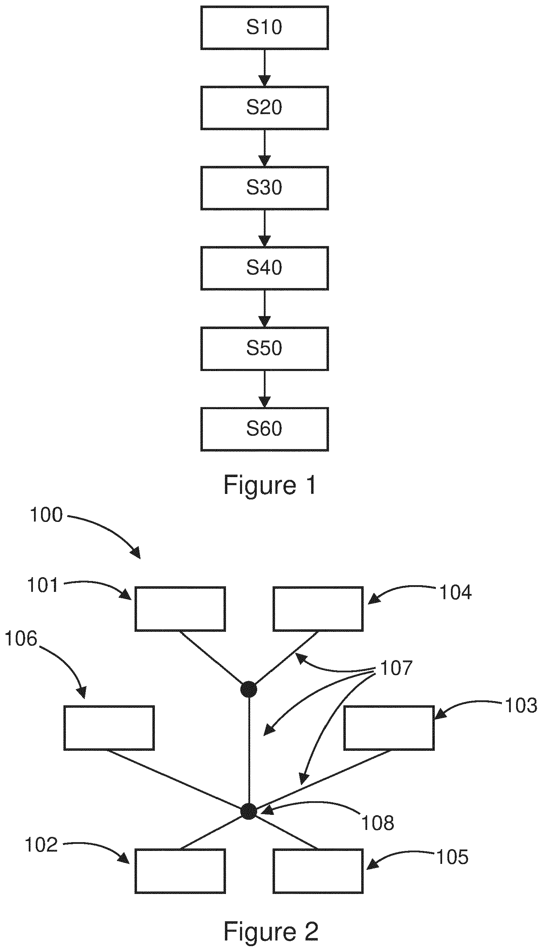

Figure 1 shows a flowchart of a computer implemented method for determining an energy ratio for consumed energy.

The step S10 comprises providing an energy network model configured to describe an energy flow between a plurality of assets in an energy network, wherein at least one asset of the plurality of assets consumes energy, wherein the energy network comprises further as assets a first energy source and the second energy source, wherein the energy flow comprises a first energy flow from the first energy source and the second energy flow from the second energy source.

The step S20 comprises receiving load demand data for the energy network and power source data for the energy network generated by the first energy source.

The step S30 comprises controlling and tracking the first energy flow from the first energy source to the plurality of assets in the energy network and the second energy flow from the second energy source to the plurality of assets in the energy network based on the energy network model and the received low demand data in the received power source data.

The step S40 comprises tracking one or more consuming times of the at least one energy consuming asset.

The step S50 comprises determining an energy ratio for the at least one energy consuming asset based on the track first energy flow and the second energy flow and the track consuming time of the at least one energy consuming asset.

The step S60 comprises providing the determined energy ratio for further processing.

Optionally the energy ratio may be used to label produced goods or to categorize goods according to their energy ratio. The first energy source may be a PV energy source. The second energy source may be an electrical grid. The energy consuming asset may be in the present example a machine tool. The energy network model may be a time-dependent network graph model. The energy network model may comprise in the present example only the aforementioned two energy sources and the one energy consuming asset. Alternatively, the energy network model may comprise a plurality of further assets. The assets may comprise as energy sources a photovoltaic system, a wind turbine, a water turbine, a electrical grid or a diesel generator and hydrogen fuel cell. The assets of the energy network are connected among each others by power lines. It should be noted that not every asset has to be connected with every other asset. For example it is a sufficient when a first energy consuming asset is connected with a first energy source and a second energy source. However a second energy consuming asset doesn't have to be connected to the first energy consuming asset. It is sufficient when the second energy consuming asset is connected with the first and/or second energy source. One or more power lines may converge at a node or a node may distribute itself to one or more power lines. The energy network model may allow to describe an energy flow between a first asset and a second asset. The energy network model may allow to describe this energy flow in both directions. The energy network model may allow to apply an uncertaintity measure to an energy flow of an energy source. It should be noted that preferably one energy source is always the electrical grid. In case the other energy sources (e.g. PV system, diesel aggregate, etc.) are not able to provide the required energy flow, the electrical grid will provide the missing energy flow in the reality. This aspect is taken into account with the uncertainty measure of the power source data. This may be advantageous as it may enable to increase the reliability of determining an energy ratio. Optionally the load demand data for the energy network and the power source data for the energy network generated by the first power source may be based on a forecast. Additionally or alternatively, the power source data for the energy network generated by the first energy source may be received in real time. Optionally, the energy load demand data of the energy network may comprise an upper bound and the power source data for the energy network generated by the first energy source may comprise a lower bound. It should be noted that this may also apply for a plurality of energy sources (e.g. a second, a third, a fourth etc.). The determining of the energy ratio may be based on an integral of the first energy flow and second energy flow over the tracked consuming time. The energy source may be one of the following: a PV system, a wind turbine, a water turbine, a diesel generator and/or a electrical grid.

Optionally, the energy network may comprise as an asset a battery energy storage for storing energy, and further comprising controlling and tracking the first energy flow from the first energy source to the battery energy storage and the second energy flow from the second energy source to the battery energy storage based on the energy network model and the received load demand data and the received power source data and tracking one or more charging times of the battery energy storage and determining an energy storage energy ratio based on the on the tracked first energy flow and the second energy flow and the tracked charging time.

Optionally, the method may further comprise controlling and tracking a first battery energy flow and a second battery energy flow from the battery energy storage to the plurality of assets in the energy network, wherein the first battery energy flow is based on a first stored energy that relates to the first energy flow and the second battery energy flow is based on a second stored energy that relates to the second energy flow, wherein the tracked first battery energy flow and second battery energy flow are used for determining the energy ratio for the at least one energy consuming asset and further tracking one or more discharging times of the battery energy storage and determining the energy storage energy ratio based on the tracked first energy flow, second energy flow, first battery energy flow, second battery energy flow, charging time and decharging time.

Optionally, the controlling and tracking the first energy flow from the first energy source to the plurality of assets in the energy network and the second energy flow from the second energy source to the plurality of assets in the energy network may further be based on a distribution logic, wherein preferably the distribution logic is dynamic.

Figure 2 shows an exemplary energy network 100.

The energy network 100 comprises in the present example six assets, namely a first energy source 101, a second energy source 102, a third energy source 103, a first energy consuming asset 104, a second energy consuming asset 105 and a battery energy storage 106. In the present example, the first energy source 101 is a PV system, the second energy source 102 is an electrical grid, the third energy source 103 is a PV system and and the first energy consuming asset 104 is a production machine and the second energy consuming asset 105 is a electric vehicle charger. The assets in the energy network 100 are connected by power lines 107 for transmission of the electrical energy. The power lines 107 run together at nodes 108 and distribute from the nodes 108. It should be noted that the energy network 100, as depicted here, shows the physical reality. The energy network 100 comprises also controls (not shown) for controlling an energy flow from the energy sources to the other assets. The energy consuming assets as well as the battery energy storage comprise also control units for controlling the respective asset. The assets may comprise further intefaces for data exchange with the data processing device configured to carry out the method described above.

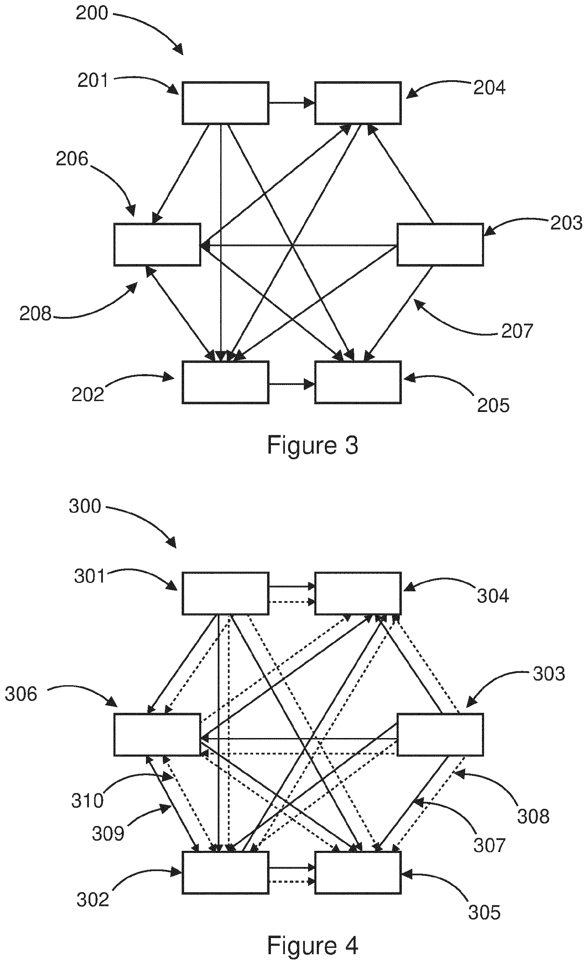

Figure 3 shows an energy network model 200.

The energy network model 200 corresponds to the energy network 100 described above. The energy network model 200 comprises the same assets as the energy network, namely a first energy source 201, a second energy source 202, third energy source 203, a first energy consuming asset 204, a second energy consuming asset 205 and a battery energy storage 206. Instead of the power lines as depicted in figure 2, the assets are connected by power lines 207 and 208. The power line 207 allows a power transfer from the first energy source 203 to the energy consuming asset 205, which is expressed by a single arrow at the end of the power line 207. The power line 208 allows a power transfer between the second energy source 202 and the battery energy storage 206 in both directions, which is expressed with each an arrow at the end of the line 208. The same applies for the other powerlines connecting the respective assets.

Figure 4 shows an energy network model 300.

The energy network model 300 differs from the energy network model depicted in figure 3 by the power lines. The energy network model 300 comprises the same assets as the energy network model 200, namely a first energy source 301, a second energy source 302, third energy source 303, a first energy consuming asset 304, a second energy consuming asset 305 and a battery energy storage 306. In contrast to figure 3, there are now two power lines 307 and 308 that connect the third energy source 303 with the second energy consuming asset 305. The first power line 307 relates to a power line that provides an energy flow from the third energy source 303 with a high probability. The second power line 308 relates to a power line that provides an energy flow with a low probability from third energy source 303 due uncertainty (e.g. stochastic effects in energy generation) and therefore is regarded as an energy flow from the second energy source 302. The energy network model 300 takes into account with this distinction the uncertainty measures that are applied to the respective energy sources. The same applies to the power lines 309 and 310 between the electrical grid 302 and the battery energy storage 306. The power line 309 relates to a power line that provides an energy flow from the battery energy storage 306 with a high probability. The second power line 310 relates to a power line that provides an energy flow with a low probability from the battery energy storage 306 due uncertainty and therefore is regarded as an energy flow from the second energy source 302. The energy network model 300 also comprises a time dependent variable, that describes the energy flow from one asset to another asset at a time t. The energy network model 300 may further comprise a battery storage variable that describes the energy stored in the battery at a time t and further variables that refer to an amount of surely stored energy from the first energy source and possible stored energy from the second energy source (e.g. the electrical). The energy network model may comprise further a set of constraints, e.g. a legal grid limit for the electrical grid. Additionally, charging and discharging efficiencies of the battery energy storage may be considered. The energy network model allows to track energy flows from each energy source to each energy consuming asset and also to each battery energy storage.

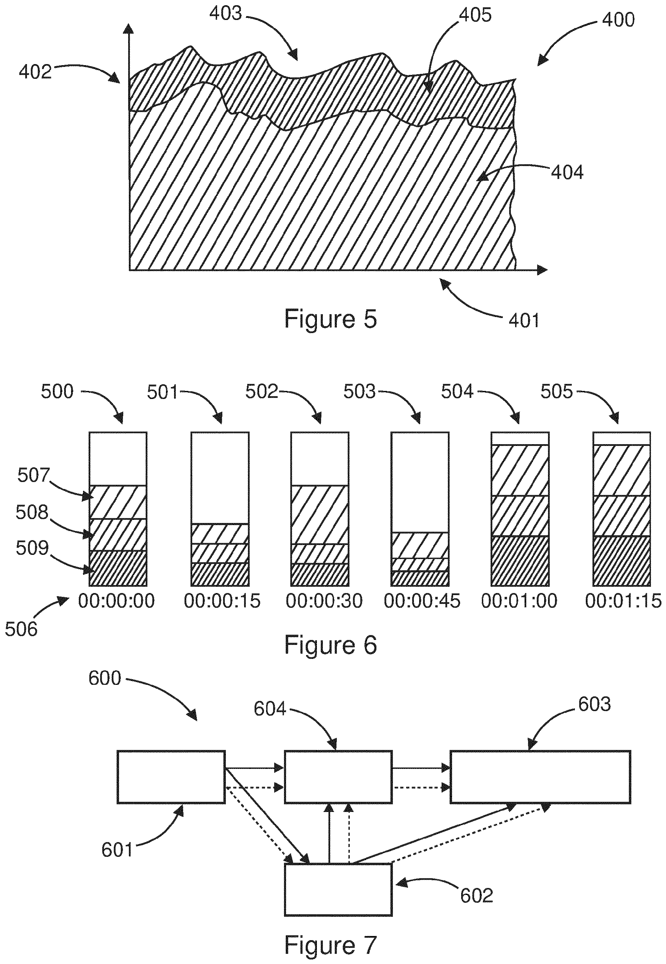

Figure 5 shows a forecast diagram 400 of a power (energy flow) of an energy source with an applied uncertainty measure.

The time is plotted on the horizontal axis 401. The power of the energy source (e.g. PV system) is plotted on the vertical axis 402. The course 403 of the power of the energy source is depicted in two areas. The lower area 404 shows the power share to which the uncertainty measure (e.g. 95%) is applied. This means for example that 95% of the power are generated with a high probability from the energy source (e.g. PV system). The higher area 405 shows the power share which is only generated with a low probability of 5% due uncertainities (e.g. stochastic effects in energy generation). The forecast may be generated using machine learning methods. Based on the forecast and the applied uncertaintity measure a lower bound may be derived. This information may be used in the energy network model to describe an energy flow from the energy source. The same aspects also apply to the load demand for an asset (e.g. machine tool). This may be advantageous to reliably forecast an amount of produced energy and consumed energy. The forecast may have a horizon from multiple days. The time step of such a forecast may comprise 1min, 5min or 10min. However also other values may be suitable.

Figure 6 shows a possible evolution of the energy content for a battery energy storage over a time. The battery energy storages 500 to 505 show the same battery energy storage at different times 506 with a time step of 15 min. The battery energy storage comprises in this example three different energies 507, 508 and 509 that stem from a first energy source (e.g. PV system), a second energy source (e.g. electrical grid) and a third energy source (e.g. wind turbine). The respective energies 507, 508 and 509 change their amount over time due to inflow and outflow.

Figure 7 shows a graph energy network 600 for the production of single good.

The energy network model 600 comprises in this example as first energy source 601 a PV system, as second energy source 602 an electrical grid, a battery energy storage 604 and as energy consuming asset 603 a machine tool. By applying the method described above, the controlling of the energy flows from the energy sources 601, 602 and the battery energy system 604 is possible and allows to produce products (e.g. milling parts) with a certain energy ratio and the determining of the energy ratio.

In the following, a summary of the main effects and main advantages of the present disclosure is provided: The invention may describe a new mathematical modeling approach for electrical networks, e.g., as they occur in energy management systems, and may allow to break down the power consumption of any load and the energy stored in battery systems into different categories, e.g., green and non-green. Traditionally, electrical networks may be modeled according to their physical topology. While one could easily measure the total power through a given line, the information which part of the power was generated by which asset, and in particular which part of the consumed energy is green and which is not, is not directly accessible.

The invention may propose a virtual tracking of the share of consumed and stored green energy at each point in time. In a further step, this may allow to generate energy consumption certificates for a site and consecutively for any kind of products, indicating how green the production process was (in terms of consumed energy). In case green products would profit from taxing benefits one day, the ability to generate those certificates may be of great importance.

Local energy networks may comprise energy generating (e.g., photovoltaic system, wind turbines, diesel generators) and energy consuming assets, battery energy storage systems, and a connection to a larger electrical grid, which serves as an infinite source of power and energy. As an example, one can think of a plant that needs energy to generate a certain product, but on the other hand has photovoltaic systems on its roof, and includes an energy storage system. Traditionally, electrical networks may be modeled according to their physical topology. While one could easily measure the total power through a given power line, the information which part of the power was generated by which asset, and in particular, which part of the consumed energy is green and which is not, is not directly accessible. This may hold in particular for battery energy systems, which do not have the capability to break down the stored energy into different origin components (or remember the shares corresponding to them), depending on the type of generation.

In contrast, there may be a growing interest in green resp. emission free production of goods. Thus, for any company it could be beneficial to track the amount of green energy, that may be used to produce their (single) goods. Furthermore, a trustworthy label or certificate which may state the share of green energy used during the production process, or the amount of saved CO2 emissions, could be of high interest.

However, the generation of such a label may be non-trivial, especially if battery energy storages are involved, as this would require a detailed tracking of green and non-green power and energy in the different parts of the energy network at any point in time.

To solve the problem described above, a new way of modeling a given energy network is presented. Instead of transferring physical power lines 1:1 into the mathematical model, the following may implemented:

For each power generating asset (i.e. energy source) (renewables, ...) - except for the grid - and for the battery energy storage, two virtual power lines may be added to any possible power receiver: one referring to (certainly) green energy and one for (possibly) non-green energy, that may be produced resp. released. Here, e.g., for renewable energy sources, the 'non-green' part may correspond to the uncertain production due to their stochastic nature. In case information on the shares of green or non-green power that is transferred from the grid to the assets is available, the method may proceed similarly for the grid. Otherwise, for the grid only one virtual power line to each possible receiver may be added.

This may allow to virtually track the way of the green and non-green power "end-to-end" through the system. In particular, the energy stored in the battery energy storage depending on its energy source (green or non-green) can also be breaked down, as well as the consumed power or energy at any point in time. Furthermore, the modeling may enable to virtually choose the share of green energy that is released from the battery energy storage at any point in time, depending on the shares of stored energy (e.g., one cannot release green energy anymore if the corresponding share is zero). In an extreme scenario, this would enable two options:

1) The production of goods employing 50% green energy for all goods.
2) The alternating production of goods employing purely green and purely non-green energy.

As in practice, the power/energy flows may be stochastic to a certain degree, uncertainty measures may be be included to give conservative statements on the consumed or stored green power/energy, that - with high probability - underestimate the green shares. This way, trustworthy statements on the (at least) employed amount of green energy can be made. This can be used to generate origin certificates for any kind of products in terms of energy.

The benefits of the proposed solution may be:

- For any energy consuming asset / battery energy storage, a virtual break down of the consumed power / energy into green resp. non-green shares at any point in time may be available.
- This may help to track how much green power was used by the site directly, stored, and reused or pushed into the grid.
- In more detail, this information can be used to generate energy origin certificates for any kind of products, indicating a lower bound for the share of green energy that was utilized during production.
- Furthermore, a virtual discharge of the single shares in the battery energy storage can be modeled, while respecting the energy balance of each share.
- Moreover, the real battery could be spitted into two dynamic parts. One that stores the local green power for further usage and the other part helps to stabilize the grid.
- One step further, this information could be utilized by energy management systems, e.g., to ensure the usage of a certain share of green energy for production at any point in time, or optimize the usage of green energy.

The idea may comprise four steps:

1. Generation of an appropriate energy network model.
2. Incorporation of uncertainty measures in the controlling unit, that controls the virtual power flows / energy flows at any point in time, which allows to conservatively track, e.g., the green energy share to a defined certainty.
3. Computation of resulting green shares in terms of power/energy consumption and energy storage at any point in time.
4. Computation of origin label / certificate.

Step 1: Model Generation

Given a physical energy network, we consider the corresponding network graph. We generate a new graph to which we transfer all assets as nodes. For each asset $A\_1$, we find all components $A\_2$, for which the network allows a transfer of power from $A\_1$ to $A\_2$, and add a virtual power line $A\_1 \rightarrow A\_2$, that directly connects $A\_1$ and $A\_2$.

In a second step, we reconsider those virtual power lines $A\_1 \rightarrow A\_2$, where $A\_1$ refers to a power generating asset (except the grid) or a battery energy storage. For those, we replace all single virtual power lines $A\_1 \rightarrow A\_2$ by two power lines, $A\_1 \rightarrow\_g A\_2$ and $A\_1 \rightarrow\_b A\_2$, where $A\_1 \rightarrow\_g A\_2$ is the virtual power line that transfers (certainly) green energy from $A\_1$ to $A\_2$, and $A\_1 \rightarrow\_g A\_2$ the one which transfers (possibly) non-green ('brown") energy.

This could be done in a similar way for the grid connection, as the share of green power could be available in real time in the future through online portals / APIs and hence the algorithm could also take care of this split.

Now, for each virtual connection $A\_1 \rightarrow\_x A\_2$ ($x \in \{g,b,\emptyset,...\}$), we add a time-dependent variable $\pi\_{(A\_1 \rightarrow\_x A\_2)}(t) \geq 0$ to our mathematical model, that describes the according virtual power flow from asset $A\_1$ to asset $A\_2$ at time $t$. In case both variables $\pi\_{(A\_1 \rightarrow\_x A\_2)}(t)$ and $\pi\_{(A\_2 \rightarrow\_x A\_1)}(t)$ exist, they can also be combined to a real-valued one, allowing also for negative values and hence reversed energy flows in the physical system. Possible constraints on the physical power lines are transferred to the virtual ones, such that for any set of feasible virtual power flows, the physical laws and constraints are met.

Furthermore, for each battery storage system B, we add a variable $\Sigma\_B(t)$, that describes the energy stored in battery B at time t, and variables $\Sigma\_{(B,g)}(t)$, and $\Sigma\_{(B,b)}(t)$, that refer to the amount of stored (surely) green and (possibly) non-green energy.

For Simplification reasons, we are only using green and brown virtual arrows to determine the energy in this case, but several more are possible; e.g. for onsite Diesel generators or to even distinguish between wind and PV.

The power flows and state of charges need to satisfy a set of constraints depending on the exact modeling, to respect, e.g., the technical grid limit, technical limits for maximal power flow through physical power lines, conservation of power and energy. Additionally, charging and discharging efficiencies of the battery when computing the state of charge as the result of the in/out outflowing power, and the fact that simultaneous in- and outflow of power may not possible, etc..

The energy network model may allow to directly track the power flows from each energy emitting asset (i.e. energy source) to each energy receiving asset (i.e. energy comsuming asset) and finally also tracking even though battery energy storages were used.

Step 2: The controlling unit and the incorporation of uncertainty measures

The power flows in the system will be steered according to a given (configurable) controller logic. The controller may compute the virtual power flows/energy flows, according to the energy network model that was generated in step 1. For each asset, the set of virtual flows may incorporate the information of total in-and outflow. Thus, the physical power flows can be easily computed from the virtual ones.

For power-outflow from battery energy storages and in principle also from electrical the grid, the enrgy network model may allow to choose the share of green and non-green power. This may be constrained by the shares of the stored energy. Thus, the modeling could allow, e.g.

a) The satisfaction of all load demands using 50% green power at all time instants
b) The timely alternating satisfaction of certain load demands using purely green and purely non-green power.

This may allow to virtually distinct, e.g., between purely green and purely non-green production. The virtual power flows may depend on the load demands and the power generated by renewable energy sources, both of which are non-controllable and in general of stochastic nature. However, for both it may be possible to reliably forecast the amount of consumed/produced power during a (short) considered time interval (e.g., using machine learning methods) and - even more important - to provide reliable upper bounds for the load, and lower bounds for the generation, that will be satisfied with very high probability.

These conservative measures may serve as input for the employed controller and compute the resulting power flows, and let the grid compensate all deviations that occur in reality (e.g. if more green energy is produced, then less energy is taken from the grid).

Step 3: Computation of green shares

For example, at time-point t_0, and that at t_0, the share of green and non-green energy may be known (e.g., algorithm may be working since start of site, production, ...). Then a time horizon [t_0,t_1] with t_1 > t_0 may be considered. According to Step 2, forecasts may be provided or received for the
lower bound of produced green energy for all assets that generate renewable energies upper bounds for all load demands and the resulting virtual power flows may be computed (encoded in the variables $\pi_{(A\_1 \rightarrow \_x A\_2)}(t)$, see above) during the interval [t_0,t_1] according to the controller logic.

Step 3a: Battery share

For a given battery energy storage B this may mean, that the different energy contents at t_0 may be known; here, for the sake of simplicity only green and none-green energy are considered. Now let $\eta_{(B,Charge)}$ describe the charging efficiency of the battery and $\pi_{(\rightarrow\_g B)}(t)$ may describe the total inflow of certainly green power at time t, and $\pi_{(\rightarrow B)}(t)$ the total inflow of all power at time t. The variables $\Sigma\_B(t)$ (stored energy at time t), $\Sigma_{(B,g)}(t)$ (stored certainly green energy at time t), and $\Sigma_{(B,b)}(t)$ (stored possibly non-green energy at time t) may update as follows:

•

$$\Sigma_B(t_1) = \Sigma_B(t_0) + \eta_{B,Charge} \int_{t_0}^{t_1} \pi_{\rightarrow B}(t)\, dt$$

•

$$\Sigma_{B_g}(t_1) = \Sigma_{B_g}(t_0) + \eta_{B,Charge} \int_{t_0}^{t_1} \pi_{\rightarrow B_g}(t)\, dt$$

•

$$\Sigma_{B_b}(t_1) = \Sigma_B(t_1) - \Sigma_{B_g}(t_1)$$

Attention: all flow variables may be either 0 or positive by definition of the problem. Additionally, mathematical constraints may exclude to have inflows and outflows at the same time, which in reality would not have any physical meaning.

Thus, at t_1 for each battery energy storage, the share of green and non-green energy stored in the battery energy storage may be known, and we may continue with the next time horizon [t_1,t_2] according to the same logic that was described before.

During discharge the same as above may apply although the efficiency, in more detail the discharge efficiency - which often may be different from the charging efficiency, may be in the denominator and there may be two possibilities to extract energy from the battery energy storag. Now, the arrow at $\pi$ may be behind the asset and hence it may describe outflow. It can distinguished between two extraction methods:

1) Each energy content $\Sigma_{(B\_g)}$ and $\Sigma_{(B\_b)}$ can be accessed individually at each extraction:

- 

$$\pi_{B_g \to}(t) = \frac{1}{\eta_{B,DisCharge}} \frac{\mathrm{d}}{\mathrm{d}t} \Sigma_{B_g}(t)$$

- 

$$\Sigma_{B_b \to}(t) = \frac{1}{\eta_{B,DisCharge}} \frac{\mathrm{d}}{\mathrm{d}t} \Sigma_{B_b}(t)$$

and hence the total energy content may be changing as well, due to $\Sigma\_B = \Sigma_{(B\_g)} + \Sigma_{(B\_b)}$:

- 

$$\pi_{B \to}(t) = \frac{1}{\eta_{B,DisCharge}} \frac{\mathrm{d}}{\mathrm{d}t} \Sigma_B(t)$$

2) The extraction $\pi_{(B\_g \to)}(t\_E)$ at $t\_E$ depends on the energy content $\Sigma_{(B\_g)}(t\_E)$ related linear to the total energy content $\Sigma\_B(t\_E)$ of the battery and both equations may be be respected simultaneously. This may mean individual categories cannot be accessed without the other, although individual categories can be routed to different locations:

- 

$$\pi_{B_g \to}(t_E) = \left[\frac{\mathrm{d}}{\mathrm{d}t} \Sigma_B(t_E)\right] \frac{1}{\eta_{B,DisCharge}} \frac{\Sigma_{B_g}(t_E)}{\Sigma_B(t_E)}$$

- 

$$\pi_{B_b \to}(t_E) = \left[\frac{\mathrm{d}}{\mathrm{d}t} \Sigma_B(t_E)\right] \frac{1}{\eta_{B,DisCharge}} \frac{\Sigma_{B_b}(t_E)}{\Sigma_B(t_E)}$$

Self-Discharge of the battery may not be given, but may act over time on the overall energy $\Sigma\_B$ of the battery energy storage.
Both versions may be possible from a mathematical view as shown above and the choice only may depend on a possible regulation.

Step 3b: Product green share

A product may be produced on Machine A2 from time t1 till t2, so the green energy used for the product on load/machine A2 could be calculated via

$$\Sigma_{Product\ on\ Machine\ A2,green}(t_1,t_2) = \int_{t_1}^{t_2} \to_g A_2(t)\,\mathrm{d}t$$

$$\Sigma_{Product\ on\ Machine\ A2,none-green}(t_1,t_2) = \int_{t_1}^{t_2} \to_b A_2(t)\,\mathrm{d}t$$

Sum over all machines that are used for the product.

$$\Sigma_{Product,green} = \mathrm{sum}_x\left(\Sigma_{Product\ on\ Machine\ x,green}\right)$$

$$\Sigma_{Product,none-green} = \mathrm{sum}_x\left(\Sigma_{Product\ on\ Machine\ x,none-green}\right)$$

which may end up in the total energy for the product:

$$\Sigma_{Product} = \Sigma_{Product,green} + \Sigma_{Product,none-green}$$

Step 4: Computation of origin label / certificate

During the production of any single good, at each point in time different devices (i.e. energy consuming assets) may be involved to produce the good. The energy network model may compute the virtual power flows for each point in time, for each device the amount of (certainly) green and (possibly) non-green power, that was consumed at each point in time, may be determined. Since it can be tracked the duration of the employment of all single devices for the production of the single good, altogether it can easily be computed the amount of (certainly) green and (possibly) non-green energy (sum of integrals of corresponding power flows over corresponding durations), see also Step 3b. This way, the energy ratio (e.g of green and nongreen energy that was employed for the production process) may be determined. This energy ratio then may become part of the origin label.

Further benefits

By adding further constraints to the model, the described mechanism can not only be used for the generation of a single good and track its individual energy contributions, but also in a more advanced setup, where two (or more) goods may be produced, but all green energy may be used for product 1, and all possibly non-green energy for product 2.

This way, different markets could be addressed. Remark, that the solution may use green energy from own PV production as well as from the grid, where the device the code may be running (resp., the solution may be computed) on may use an API to read the current green energy share and may calculate as above the certainly green share and the none-green share. Hence, it may allow for virtual separation of the energy resp. power origin.

LIST OF REFERENCE SIGNS:

| | |
|---|---|
| S10 | providing energy network model |
| S20 | receiving load demand data and power source data |
| S30 | controlling and tracking energy flows |
| S40 | tracking consuming times |
| S50 | determining energy ratio |
| S60 | providing energy ratio |
| 100 | energy network |
| 101 | first energy source |
| 102 | second energy source |
| 103 | third energy source |
| 104 | first energy consuming asset |
| 105 | second energy consuming asset |
| 106 | battery energy storage |
| 107 | power line |
| 108 | node |
| 200, 300 | energy network model |
| 201, 301, | first energy source |
| 202, 302 | second energy source |
| 203, 303 | third energy source |
| 204, 304 | first energy consuming asset |

| | |
|---|---|
| 205, 305 | second energy consuming asset |
| 206, 306 | battery energy storage |
| 207, 208, 307, 308, 309, 310 | power lines |
| 400 | forecast |
| 401 | horizontal axis |
| 402 | vertical axis |
| 403 | course of power |
| 404 | higher area |
| 405 | lower area |
| 500, 501, 502, 503, 504, 505 | battery energy storage |
| 506 | time steps |
| 507, 508, 509 | respective energies |
| 600 | energy network model |
| 601 | first energy source |
| 602 | second energy source |
| 603 | energy consuming asset |
| 604 | battery energy storage |

**Claims**

1. Computer-implemented method for determining an energy ratio for a consumed energy comprising:

    Providing an energy network model configured to describe an energy flow between a plurality of assets in an energy network, wherein at least one asset of the plurality of assets consumes energy, wherein the energy network comprises further as assets a first energy source and a second energy source, wherein the energy flow comprises a first energy flow from the first energy source and a second energy flow from the second energy source;
    Receiving a load demand data for the energy network and power source data for the energy network generated by the first energy source;
    Controlling and tracking the first energy flow from the first energy source to the plurality of assets in the energy network and the second energy flow from the second energy source to the plurality of assets in the energy network based on the energy network model and the received load demand data and the received power source data;
    Tracking one or more consuming times of the at least one energy consuming asset,
    Determining an energy ratio for the at least one energy consuming asset based on the tracked first energy flow and the second energy flow and the tracked consuming time of the at least one energy consuming asset;
    Providing the determined energy ratio for further processing.

2. The method according to claim 1, wherein the determining the energy ratio is based on an integral of the first energy flow and second energy flow over the tracked consuming time.

3. The method according to claim 1 or 2, wherein the load demand data for the energy network and the power source data for the energy network generated by the first energy source is based on a forecast.

4. The method according to any one of the preceding claims, wherein the power source data for the energy network generated by the first energy source is received in realtime.

5. The method according to any one of the preceding claims, wherein the load demand data for the energy network and the power source data for the energy network generated by the first energy source are associated with respective uncertaintity measures.

6. The method according to any one of the preceding claims, wherein the load demand data for the energy network comprises an upper bound and the power source data for the energy network generated by the first energy source comprise a lower bound.

7. The method according to any one of the preceding claims, wherein the energy source is one of the following: photovoltaic system, wind turbine, water turbine, electrical grid, diesel generator and/or wherein the second energy source is an electrical grid.

8. The method according to any one of the preceding claims, wherein the energy network model is a time dependent network graph model.

9. The method according to any one of the preceding claims, wherein the energy network comprises as an asset a battery energy storage for storing energy, and further comprising controlling and tracking the first energy flow from the first energy source to the battery energy storage and the second energy flow from the second energy source to the battery energy storage based on the energy network model and the received load demand data and the received power source data and tracking one or more charging times of the battery energy storage and determining an energy storage energy ratio based on the on the tracked first energy flow and the second energy flow and the tracked charging time.

10. The method according to claim 9, further comprising controlling and tracking a first battery energy flow and a second battery energy flow from the battery energy storage to the plurality of assets in the energy network, wherein the first battery energy flow is based on a first stored energy that relates to the first energy flow and the second battery energy flow is based on a second stored energy that relates to the second energy flow, wherein the tracked first battery energy flow and second battery energy flow are used for determining the energy ratio for the at least one energy consuming asset and further tracking one or more decharging times of the battery energy storage and determining the energy storage energy ratio based on the tracked first energy flow, second energy flow, first battery energy flow, second battery energy flow, charging time and decharging time.

11. The method according to any one of the preceding claims, wherein the controlling and tracking the first energy flow from the first energy source to the plurality of assets in the energy network and the second energy flow from the second energy source to the plurality of assets in the energy network is further based on a distribution logic, wherein preferably the distribution logic is dynamic.

12. The method according to any one of the preceding claims, wherein more than one asset of the plurality of assets consume energy.

13. A data processing device comprising means for carrying out the method of any one of the claims 1 to 12.

14. A computer program comprising instructions which, when the program is executed by a computer, cause the computer to carry out [the steps of] the method of any one of the claims 1 to 12.

15. A computer-readable medium comprising instructions which, when executed by a computer, cause the computer to carry out the method according to any one of the claims 1 to 12.

Figure 1

Figure 2

Figure 3

Figure 4

Figure 5

Figure 6

Figure 7

Europäisches
Patentamt

European
Patent Office

Office européen
des brevets

# EUROPEAN SEARCH REPORT

**Application Number**

EP 23 18 0689

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/372345 A1 (BAIN NICHOLAS JORDAN [US] ET AL) 5 December 2019 (2019-12-05) <br> * abstract * <br> * paragraph [0080] * <br> * paragraphs [0087], [0088] * <br> * paragraphs [0094] – [0102] * <br> * paragraphs [0114] – [0119] * <br> * paragraph [0158] * <br> * paragraph [0202] * <br> * paragraph [0265] * <br> * paragraphs [0328] – [0342]; figure 1A * <br> * paragraphs [0379] – [0382]; figure 2 * <br> ----- | 1-15 | INV. <br> G06Q10/0639 <br> G06Q50/06 |
| A | US 2010/235008 A1 (FORBES JR JOSEPH W [US] ET AL) 16 September 2010 (2010-09-16) <br> * abstract * <br> * paragraphs [0023] – [0035] * <br> * paragraphs [0048] – [0059]; figure 1 * <br> ----- | 1-15 | |
| A | WO 2020/141175 A2 (VITO NV [BE]) 9 July 2020 (2020-07-09) <br> * abstract * <br> * page 11, line 1 – page 18, line 12 * <br> * page 23, line 21 – page 31, line 18; figure 1 * <br> ----- | 1-15 | TECHNICAL FIELDS SEARCHED (IPC) <br><br> G06Q |
| A | US 2015/032278 A1 (BHAGERIA GOPAL K [US] ET AL) 29 January 2015 (2015-01-29) <br> * abstract * <br> * paragraphs [0004] – [0006] * <br> * paragraphs [0030] – [0067]; figures 1-3 * <br> ----- <br><br> -/-- | 1,13-15 | |

The present search report has been drawn up for all claims

| Place of search | Date of completion of the search | Examiner |
|---|---|---|
| Munich | 23 November 2023 | Dedek, Frédéric |

EPO FORM 1503 03.82 (P04C01)

## EUROPEAN SEARCH REPORT

Application Number

EP 23 18 0689

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | STEFAN AMBEC ET AL: "Electricity provision with intermittent sources of energy", RESOURCE AND ENERGY ECONOMICS, ELSEVIER, AMSTERDAM, NL, vol. 34, no. 3, 12 January 2012 (2012-01-12), pages 319-336, XP028489767, ISSN: 0928-7655, DOI: 10.1016/J.RESENEECO.2012.01.001 [retrieved on 2012-01-24] * abstract * | 5 | |
| A | SHARIFZADEH MAHDI ET AL: "Integrated renewable electricity generation considering uncertainties: The UK roadmap to 50% power generation from wind and solar energies", RENEWABLE AND SUSTAINABLE ENERGY REVIEWS, ELSEVIERS SCIENCE, NEW YORK, NY, US, vol. 72, 17 January 2017 (2017-01-17), pages 385-398, XP029963383, ISSN: 1364-0321, DOI: 10.1016/J.RSER.2017.01.069 * abstract * | 7 | TECHNICAL FIELDS SEARCHED (IPC) |
| A | MARRASSO E ET AL: "Electric efficiency indicators and carbon dioxide emission factors for power generation by fossil and renewable energy sources on hourly basis", ENERGY CONVERSION AND MANAGEMENT, ELSEVIER SCIENCE PUBLISHERS, OXFORD, GB, vol. 196, 8 July 2019 (2019-07-08), pages 1369-1384, XP085796342, ISSN: 0196-8904, DOI: 10.1016/J.ENCONMAN.2019.06.079 [retrieved on 2019-07-08] * abstract * * sections 1 - 3 * | 7 | |

The present search report has been drawn up for all claims

| Place of search | Date of completion of the search | Examiner |
|---|---|---|
| Munich | 23 November 2023 | Dedek, Frédéric |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 23 18 0689

This annex lists the patent family members relating to the patent documents cited in the above-mentioned European search report.
The members are as contained in the European Patent Office EDP file on
The European Patent Office is in no way liable for these particulars which are merely given for the purpose of information.

23-11-2023

| Patent document cited in search report | | | Publication date | Patent family member(s) | | | Publication date |
|---|---|---|---|---|---|---|---|
| US 2019372345 | A1 | | 05-12-2019 | AU | 2018219961 | A1 | 19-09-2019 |
| | | | | EP | 3580719 | A2 | 18-12-2019 |
| | | | | JP | 2020510945 | A | 09-04-2020 |
| | | | | US | 2019372345 | A1 | 05-12-2019 |
| | | | | US | 2023006444 | A1 | 05-01-2023 |
| | | | | WO | 2018148732 | A2 | 16-08-2018 |
| US 2010235008 | A1 | | 16-09-2010 | AU | 2010250121 | A1 | 15-12-2011 |
| | | | | CA | 2762387 | A1 | 25-11-2010 |
| | | | | EP | 2433190 | A1 | 28-03-2012 |
| | | | | KR | 20120016145 | A | 22-02-2012 |
| | | | | KR | 20130061192 | A | 10-06-2013 |
| | | | | US | 2010235008 | A1 | 16-09-2010 |
| | | | | WO | 2010134987 | A1 | 25-11-2010 |
| WO 2020141175 | A2 | | 09-07-2020 | EP | 3906601 | A2 | 10-11-2021 |
| | | | | WO | 2020141175 | A2 | 09-07-2020 |
| US 2015032278 | A1 | | 29-01-2015 | NONE | | | |

EPO FORM P0459

For more details about this annex : see Official Journal of the European Patent Office, No. 12/82